# EUROPEAN PATENT SPECIFICATION

(11) **EP 2 082 481 B1**
(45) Date of publication and mention of the grant of the patent: **05.05.2010**
(21) Application number: 07826663.2
(22) Date of filing: 05.10.2007
(51) Int. Cl.: H03H 3/007, H03H 9/24

(54) **RESONATOR**
RESONATOR
RÉSONATEUR

(30) Priority: 09.10.2006 EP 06122002
(43) Date of publication of application: 29.07.2009
(73) Proprietor: NXP B.V., 5656 AG Eindhoven (NL)
(72) Inventor: NGUYEN HOANG, Viet, NL-5656 AG Eindhoven (NL); GRAVESTEIJN, Dirk, Redhill Surrey RH1 5HA (GB); SURDEANU, Radu, NL-5656 AG Eindhoven (NL)
(74) Representative: Burton, Nick
(86) International application number: PCT/IB2007/054071
(87) International publication number: WO 2008/044182

(56) References cited:
- WO-A-03/100969
- YONGXUN LIU ET AL: "Flexible threshold voltage 4-terminal FinFETs" INTEGRATED CIRCUIT DESIGN AND TECHNOLOGY, 2004. ICICDT '04. INTERNATIONAL CONFERENCE ON AUSTIN, TX, USA 17-20 MAY 2004, PISCATAWAY, NJ, USA,IEEE, US, 17 May 2004 (2004-05-17), pages 91-96, XP010726234 ISBN: 0-7803-8528-4
- BARTHOLOMEYCZIK J ET AL: "Microelectromechanical HF Resonators Fabricated Using a Novel SOI-Based Low-Temperature Process" IEEE SENSORS JOURNAL, IEEE SERVICE CENTER, NEW YORK, NY, US, vol. 5, no. 5, October 2005 (2005-10), pages 1112-1119, XP011138640 ISSN: 1530-437X

## Description

The invention relates to a method of making a resonator, and in particular to a method of making a nano resonator.

Resonators are required in radio frequency (RF) circuits. A traditional resonator is a quartz crystal, which provides a high quality (q-) factor resonator. However, such resonators are bulky discrete devices which makes them less suitable for compact mobile applications. A smaller resonator would be preferable.

For this reason, microelectromechanical systems (MEMS) resonators have been investigated. These have a q- factor comparable to a good quartz resonator and have a much smaller form factor. They have the additional advantage that they can be mass-produced using silicon technology and so they can be made at relatively low cost.

However, MEMS resonators have some disadvantages. They are discrete devices, which are not fully compatible with CMOS processing. They require a relatively high operation voltage, for example about 10V, compared with the voltage required for standard CMOS operation of about 1.2V. A relevant parameter is motional resistance, which is the ratio between the input voltage and output current of the resonator. The motional resistance of such resonators is relatively high (MΩ), and the resonant frequency relatively low. These factors limit circuit design freedom and increase power consumption.

A number of other resonator structures have been proposed.

One example is described in WO 02/078075 which describes a fabrication method for semiconductor devices that may be used to manufacture a bridge over a trench. The bridge may be free to oscillate. The approach used has a number of disadvantages. Most importantly, the method described uses a wafer bonding step which makes processing much more complicated and makes the method incompatible with standard CMOS processes. Secondly, the approach used to form the bridge is lithography followed by reactive ion etching (RIE) which limits the spacing of the elements.

WO 03/100969 disposes a method of producing a microsystem structure with lateral gaps. Yongxun Liu et al : "Flexible threshold voltage 4-terrninal FinFETs" Integrated Circuit Design and Technology, 2004. ICICDT '04 International Conference on Austin, TX, USA 17-20 May 2004, disclose Four-terminal FinFETs with independent double gates and an ideal rectangular cross-section Si-fin channel beinn fabricated by using orientation-dependent wet etching.

Thus, there remains a need for a resonator overcoming some or all of these disadvantages.

According to the invention, there is provided a method of making a resonator according to claim 1.

The method is a straightforward route to manufacturing resonators that may be extremely small, and closely spaced to their electrodes, in a way that is compatible with conventional processing. This is unlike the approach of WO02/078075 that requires a wafer bonding step which is not normally present in conventional manufacturing lines. Further, the size of the gaps can be as low as the thickness of gate oxide. Gate oxide can be manufactured to very precise thicknesses and so the method according to the invention can deliver very precise spacings of the electrodes from the resonator.

The invention also relates to a method of manufacturing a semiconductor device including such a resonator, by:
providing a substrate;
forming a buried oxide layer on the substrate;
forming a resonator on the substrate in a resonator region of the substrate using the above method and forming at least one active device on at least one active device region of the substrate;
depositing and patterning a thermal decomposable polymer over the resonator region;
depositing a permeable dielectric layer over the active device region and over thermal decomposable polymer over the resonator region;
heating the device to decompose the thermal decomposable polymer to form a second cavity.

For a better understanding of the invention, embodiments will now be described, purely by way of example, with reference to the accompanying drawings, in which:
Figure 1 shows a side view of a step in the manufacture of a resonator according to the invention;
Figure 2 shows a top view of the step of Figure 1;
Figures 3 to 5 show side views of intermediate steps used to reach the step shown in Figure 1;
Figure 6 shows a side view of a subsequent step in the method;
Figure 7 shows a top view of the step of Figure 6;
Figure 8 shows a resonator with a gas sensitive layer; and
Figures 9 to 14 show side views in the manufacture of an integrated device including the resonator.

Like or similar components are give the same reference numerals in the different figures, which are schematic and not to scale.

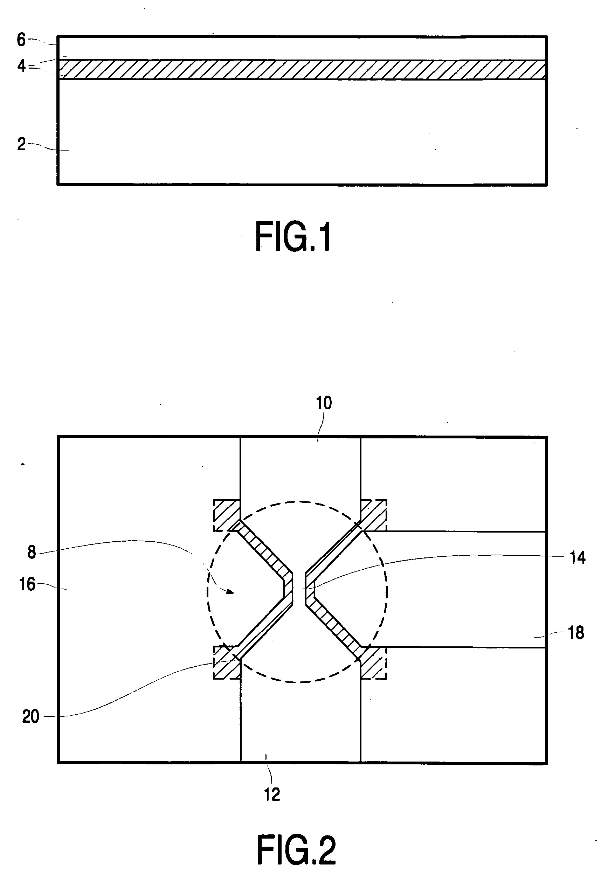

Referring to Figures 1 and 2, a structure is formed on a semiconductor substrate 2 with an oxide layer 4 formed thereon. A semiconductor layer 6 is formed over the buried oxide layer 4. In the embodiment, both the substrate and the semiconductor layer 6 are of silicon.

The semiconductor layer 6 is patterned to form a FINFET (fin-Field effect transistor) structure as shown in Figure 2. Such a structure includes first and second electrodes 10, 12 both of which taper in a central region 8 and which connect to a narrow central bar 14. In a FINFET acting as such, the first and second electrodes (10,12) are the source and drain.

The FINFET structure also includes third and fourth electrodes 16,18 which likewise taper in the central region 8 and which surround the central bar 14. The third and fourth electrodes 16, 18 are arranged on either side of the central bar 14 and spaced from it by thin insulating oxide 20. These third and fourth electrodes 16,18 act as gate electrodes when the FINFET is used as such.

A number of approaches are known to making such FINFET structures. Note that the invention does not require the FINFET structure to operate as such, and the term FINFET structure is accordingly used in the present invention to describe a like structure to a FINFET such as, for example, the structure illustrated in Figures 1 and 2, or other similar structures with a narrow channel extending longitudinally spaced by lateral insulator from opposed gate electrodes.

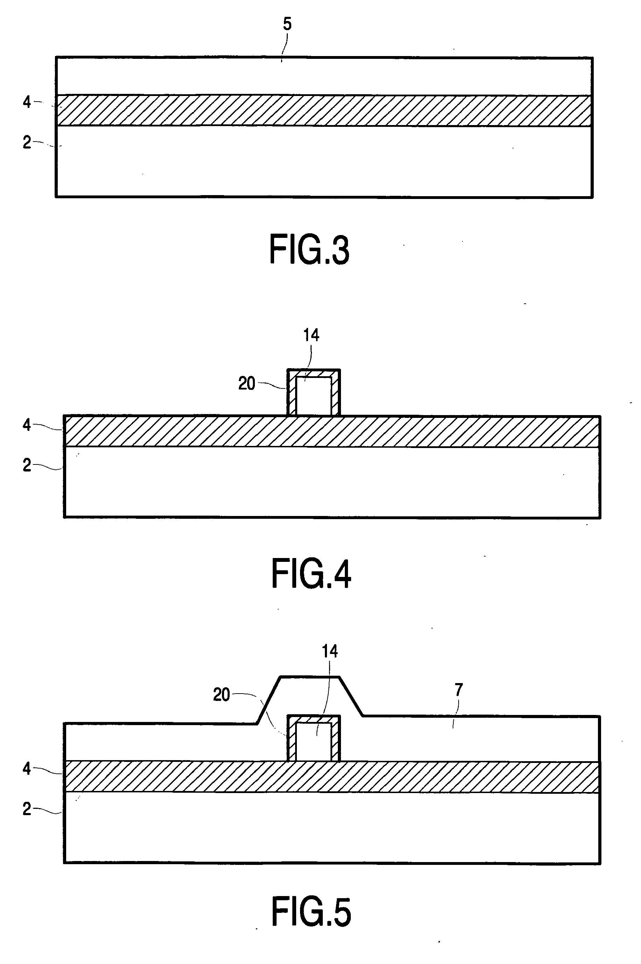

The process flow may be the following, as illustrated in Figures 3 to 5.

A SiO₂ layer 4 is formed on a Si wafer 2. A first semiconductor layer 5 of 65nm (100) Si layer is then deposited on the SiO₂ layer as shown in Figure 3. This layer is then patterned using a 60nm thick SiON hard mask to form the first and second electrodes.

Next, the wafer is surface cured by dry oxidation and annealing in a reducing atmosphere. An oxide layer 20 of silicon dioxide is then deposited. This step is illustrated in Figure 4.

Amorphous silicon as second semiconductor layer 7 is then deposited to a thickness of 200nm and etched back to 140nm as illustrated in Figure 5. A 60nm oxide is then deposited and patterned to form a hard mask which is then used to pattern the third and fourth electrodes to define them in the amorphous silicon layer over the first and second electrodes.

An implantation step is then carried out using a tilted process of As for NMOS or BF₂ for CMOS. The hard mask forming the third and fourth electrodes is then removed. At this stage, there is still amorphous silicon over the top of the central bar since it is not possible to pattern the third and fourth electrodes to stop exactly at the edge of the central bar 14.

A CMP step is then carried out to remove this amorphous silicon and hence form the structure of Figures 1 and 2.

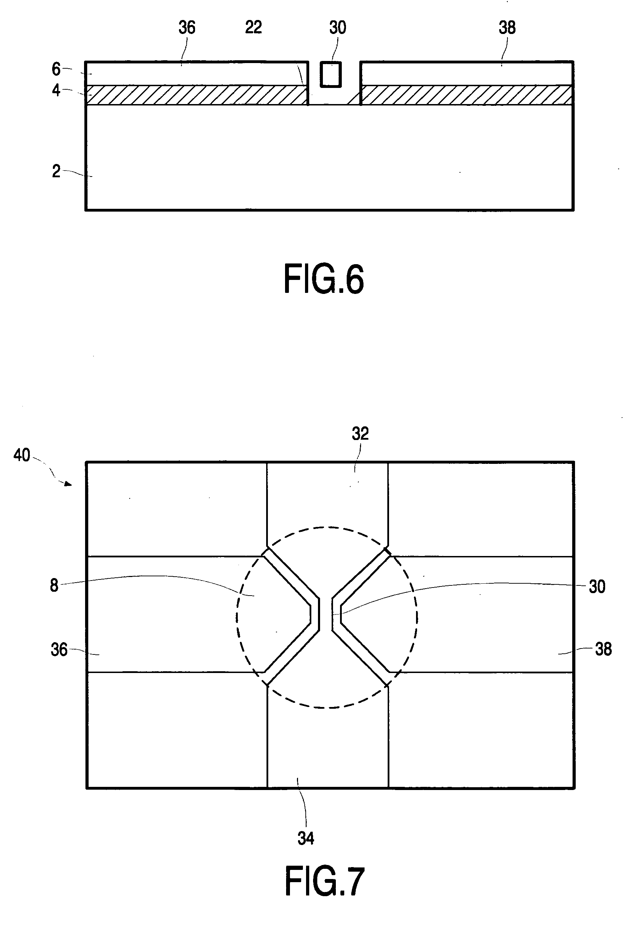

Referring to Figures 6 and 7, a selective etch step is then used to etch away oxide in the central region 8, removing both the buried oxide layer 4 under the central region to form cavity 22 and the insulating layer 20 from either side of the central bar which thus forms a free resonator element 30. Any suitable selective etch may be used, including for example buffered HF.

The resonator element 30 is connected to the first and second electrodes 10,12 which form resonator anchor 32,34. The third electrode 16 becomes the control electrode 36 spaced from the resonator element 30 and the fourth electrode 18 becomes the sense electrode 38 likewise spaced from the resonator element.

Since the gap between the third and fourth electrodes 16,18 and the resonator element 30 is defined by the thickness of the gate oxide, it can be very precisely defined. In particular, in embodiments the gap may be controlled to an accuracy of 0.1 nm and hence very small gaps can be accurately defined.

In use, the control electrode may be used to induce vibration in the resonator element to force it to resonate. The sensing electrode can measure induced current which reaches its maximum value at the resonant frequency.

The gate oxide in the FINFET structure can be very small, in the range 1 nm to 1µm, but typically towards the lower end of this range, preferably less than 100nm, further preferably less than 10nm. One benefit of the invention is that this oxide thickness determines the gap between the resonator 30 and the electrodes 36,38 which is accordingly highly controllable.

A further benefit is that when the gap is small only a small voltage is needed to drive the resonator and further a large induced current is achievable.

The method allows the size of the resonator element to be easily adjusted, for example over the range 10nm to several µm during the lithographic steps manufacturing the FINFET structure and this in turn means that the resonant frequency can be adjusted over a wide range as required. in particular, the method should achieve resonant frequencies up to several tens of GHz which is well above the frequency achieved in MEMS resonator. Preferably, the maximum thickness and width of the central bar is less than 500nm, further preferably less than 200nm, and further preferably less than 100nm, which can deliver a motional resistance of a few Ω or less.

All this results in a low power device that can be included in complex circuits.

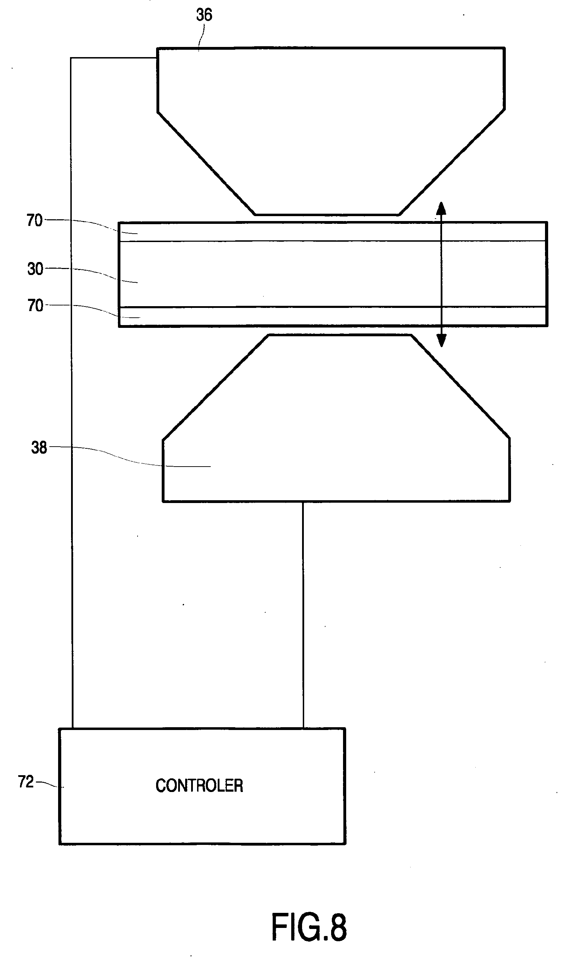

One application of the device is as a sensor. A gas-sensitive layer 70 is coated on the resonator 30 (Figure 8) and when a gas molecule is absorbed onto the gas sensitive layer 70 it changes the total mass of the resonator and hence the resonant frequency. The frequency shift is measured by detector 72 and this provides a measure of the concentration of the gas. The small size of the resonator 30 allows for high resolution detection, for example for an electronic nose for security applications.

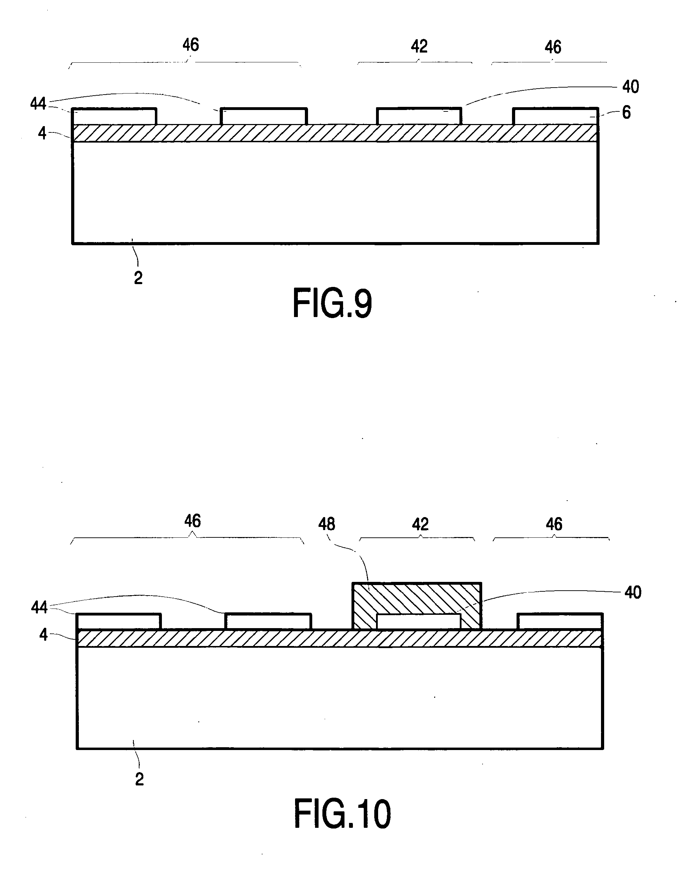

The resonator, whether or not an electronic nose, may be integrated into a CMOS device, as illustrated in Figures 9 to 14.

Referring to Figure 9, CMOS active devices 44 are manufactured in semiconductor layer 6 in active device regions 46, and a resonator 40 is manufactured in resonator region 42 as described above with reference to Figures 1 to 7.

Then, a thermal decomposable polymer (TDP) 48 is deposited over the entire surface and patterned to be present in the resonator region 42 (Figure 10). Normally, the TDP is removed from the active device regions 46 but this is not essential and if TDP is required over part of these active device regions 46 it may be applied there in the same steps.

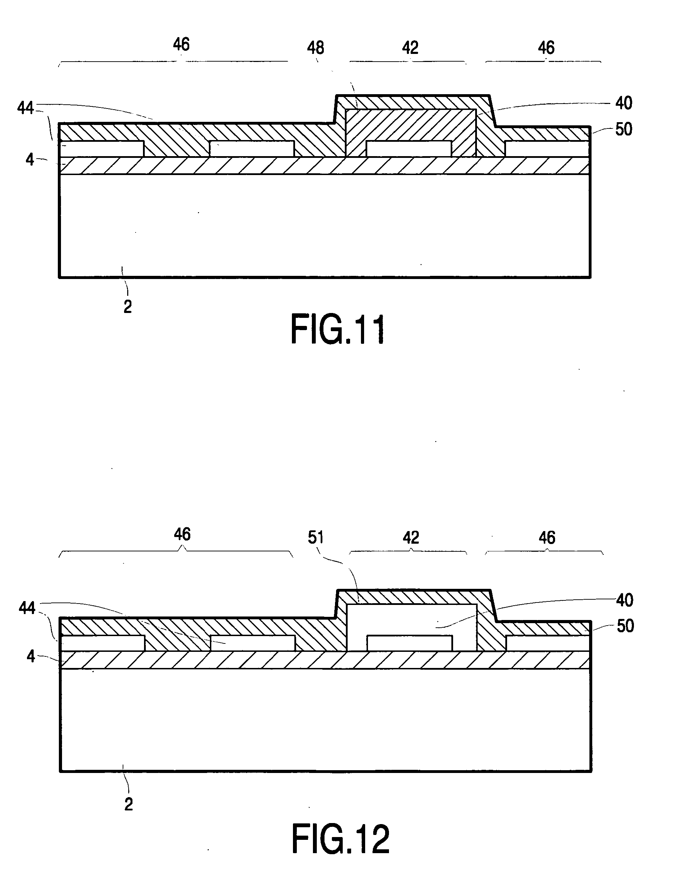

A permeable dielectric layer 50 is then deposited over the whole surface, i.e. over the TDP 48 where present and the active devices 44 in active device regions 46 (Figure 11).

A heating step is then used to decompose the TDP 48 leaving a second cavity 51 under the dielectric layer 50 over the resonator 40 (Figure 12).

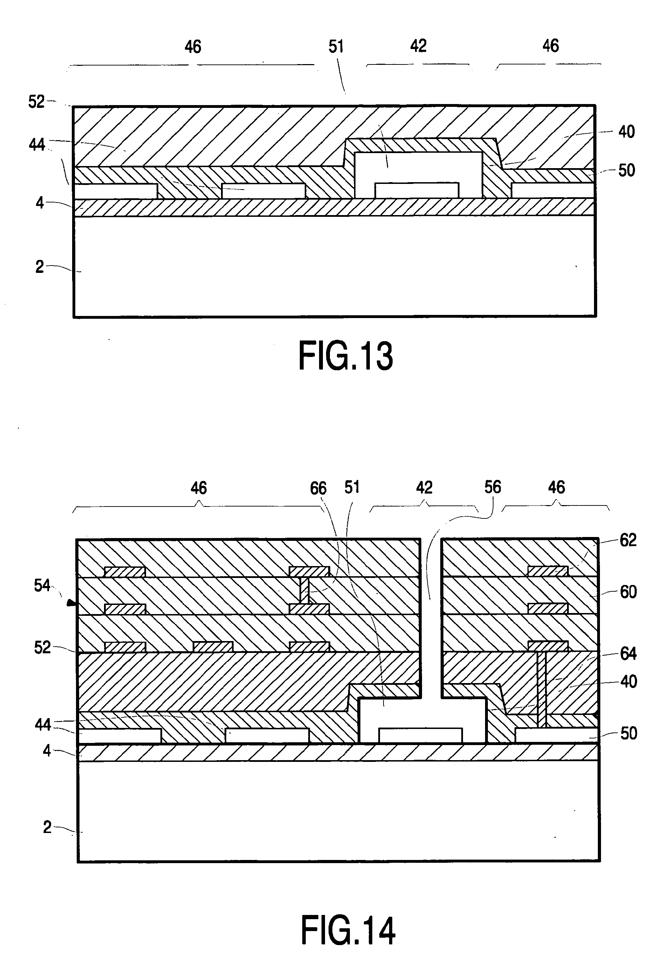

A premetal dielectric (PMD) layer 52 is then deposited over the surface and planarised, in the embodiment described using a chemical-mechanical polishing (CMP) step (Figure 13). Other planarisation methods may also be used if preferred. The PMD layer 52 and dielectric layer 50 effectively encapsulate the resonator 40.

Then, a multilayer metallisation 54 is deposited. This includes a number of insulating dielectric layers 60, horizontal interconnect metallisation 62, as well as vias 64 connecting to the active devices 44 and also vias 66 connecting different levels of the multilevel metallisation. Connections to the resonator may be by lateral interconnections (not shown) over the buried oxide layer 4.

For applications requiring the resonator to be in contact with the surroundings, for example in measurement applications, an additional step is then provided to etch opening 56 from the upper surface of the multilayer metallisation 54 though the PMD layer 52 and dielectric layer 50 to cavity 51. This opening may be used, for example, in the chemical sensor approach of Figure 8. This step of creating the opening 56 may be omitted for applications in which the resonator does not need to be in contact with the surroundings.

This results in the arrangement shown in Figure 14. The device may now be finished and packaged as is known in the art.

Those skilled in the art will realise that the above embodiment may be varied. For example, the semiconductor material need not be silicon, and a large variety of manufacturing steps may be introduced as required. In particular, the devices 44 need not be CMOS devices but may be any semiconductor devices as required.

## Claims

1. A method of manufacturing a resonator (40), comprising:
forming a FINFET structure with a substrate (2), a buried oxide layer (4) on the substrate (2), a semiconductor layer (6) on the buried oxide layer, the semiconductor layer being patterned to define four semiconductor regions coming together in a central region (8), the four regions including opposed first and second (10,12) regions linked by a central bar (14) and opposed third and fourth regions (16, 18) on either side of the central bar (14), with oxide insulator (20) between each the third and fourth regions (16,18) and the central bar (14); and
selectively etching the buried oxide layer (4) and the oxide insulator (20) in the central region (8) to form a cavity (22) under the central bar (14) and to etch away the oxide insulator (20) between the third and fourth regions (16,18) and the central bar so that the central bar (14) forms a resonator element (30), the first and second regions form resonator anchors (32,34), and the third and fourth regions form control and sensing electrodes (36,38).

2. A method according to claim 1 wherein the step of forming a FINFET structure includes:
forming a first semiconductor layer (5) on the buried oxide layer;
patterning the first semiconductor layer (5) to form the first and second regions (10,12) and the central bar (14);
depositing the oxide insulator (20) on the central bar (14);
depositing a second semiconductor layer (7); and
patterning the second semiconductor layer (7) to form the third and fourth region (16,18) on either side of the central region separated from the central bar (14) by the oxide insulator.

3. A method according to claim 2, wherein the step of pattering the second semiconductor layer includes carrying out a chemical mechanical polishing step to remove the second semiconductor layer (7) above a predetermined level to remove the second semiconductor layer from above the central bar (14).

4. A method according to claim 2 or 3 wherein the steps of patterning at least one of the first semiconductor layer and the second semiconductor layer include forming a hard mask, patterning the hard mask and then using the hard mask to etch the respective semiconductor layer.

5. A method of manufacturing a semiconductor device including a resonator, the method comprising:
providing a substrate (2);
forming a buried oxide layer (4) on the substrate (2);
forming a resonator (40) on the substrate in a resonator region (42) of the substrate using a method according to any of claims 1 to 4 and forming at least one active device (44) on at least one active device region (46) of the substrate;
depositing and patterning a thermal decomposable polymer (48) over the resonator region (42);
depositing a permeable dielectric layer (50) over the active device region (46) and over thermal decomposable polymer (48) over the resonator region (42);
heating the device to decompose the thermal decomposable polymer to form a second cavity (51).

6. A method of manufacturing a semiconductor device including a resonator according to claim 5 further comprising, after the step of heating the device to decompose the thermal decomposable polymer, depositing a premetal dielectric (52) over the permeable dielectric layer (50), and planarising the premetal dielectric (52) by chemical-mechanical polishing.

7. A method of manufacturing a semiconductor device including a resonator according to claim 6 further comprising forming a multi-layer metallisation (54) over the premetal dielectric (52).

8. A method according to any of claims 5 to 7 further comprising etching an opening (56) from the upper surface of the semiconductor device through the permeable dielectric layer (50) to the second cavity (51) to expose the cavity.

## Patentansprüche

1. Verfahren zum Herstellen eines Resonators (40), umfassend:
Bilden einer FINFET-Struktur mit einem Substrat (2), einer vergrabenen Oxidschicht (4) auf dem Substrat (2) und einer Halbleiterschicht (6) auf der vergrabenen Oxidschicht, wobei die Halbleiterschicht strukturiert wird, um vier Halbleitergebiete zu definieren, die sich in einem Zentralgebiet (8) treffen, wobei die vier Gebiete gegenüberliegende erste und zweite Gebiete (10, 12), die durch einen Zentralstreifen (14) verbunden sind, und gegenüberliegende dritte und vierte Gebiete (16, 18) auf beiden Seiten des Zentralstreifens (14) enthalten, wobei zwischen jeweils dem dritten und vierten Gebiet (16, 18) und dem Zentralstreifen (14) ein Oxidisolator (20) angeordnet ist; und
selektives Ätzen der vergrabenen Oxidschicht (4) und des Oxidisolators (20) im Zentralgebiet (8), um einen Hohlraum (22) unter dem Zentralstreifen (14) zu bilden und den Oxidisolator (20) zwischen dem dritten und vierten Gebiet (16, 18) und dem Zentralstreifen wegzuätzen, so dass der Zentralstreifen (14) ein Resonatorelement (30) bildet, die ersten und zweiten Gebiete Resonatoranker (32, 34) bilden und die dritten und vierten Gebiete Steuer- und Messelektroden (36, 38) bilden.

2. Verfahren nach Anspruch 1, wobei der Schritt des Bildens einer FINFET-Struktur enthält:
Bilden einer ersten Halbleiterschicht (5) auf der vergrabenen Oxidschicht;
Strukturieren der ersten Halbleiterschicht (5), um die ersten und zweiten Gebiete (10, 12) und den Zentralstreifen (14) zu bilden;
Abscheiden des Oxidisolators (20) auf dem Zentralstreifen (14);
Abscheiden einer zweiten Halbleiterschicht (7); und
Strukturieren der zweiten Halbleiterschicht (7), um das dritte und das vierte Gebiet (16, 18) auf beiden Seiten des Zentralgebiets durch den Oxidisolator getrennt vom Zentralstreifen (14) zu bilden.

3. Verfahren nach Anspruch 2, wobei der Schritt des Strukturierens der zweiten Halbleiterschicht das Ausführen eines chemisch-mechanischen Polierschrittes enthält, um die zweite Halbleiterschicht (7) oberhalb eines vorgegebenen Niveaus zu entfernen, um die zweite Halbleiterschicht von oberhalb des Zentralstreifens (14) zu entfernen.

4. Verfahren nach Anspruch 2 oder 3, wobei die Schritte des Strukturierens wenigstens der ersten Halbleiterschicht und/oder der zweiten Halbleiterschicht das Bilden einer Hartmaske, das Strukturieren der Hartmaske und anschließend das Verwenden der Hartmaske zum Ätzen der entsprechenden Halbleiterschicht umfasst.

5. Verfahren zur Herstellung einer Halbleitervorrichtung, die einen Resonator enthält, wobei das Verfahren umfasst:
Bereitstellen eines Substrats (2);
Bilden einer vergrabenen Oxidschicht (4) auf dem Substrat (2);
Bilden eines Resonators (40) auf dem Substrat in einem Resonatorgebiet (42) des Substrats unter Verwendung eines Verfahrens nach irgendeinem der Ansprüche 1 bis 4, und Bilden wenigstens einer aktiven Vorrichtung (44) auf wenigstens einem aktiven Vorrichtungsgebiet (46) des Substrats;
Abscheiden und Strukturieren eines thermisch zersetzbaren Polymers (48) über dem Resonatorgebiet (42);
Abscheiden einer permeablen dielektrischen Schicht (50) über dem aktiven Vorrichtungsgebiet (46) und über dem thermisch zersetzbaren Polymer (48) über dem Resonatorgebiet (42); und
Erhitzen der Vorrichtung, um das thermisch zersetzbare Polymer zu zersetzen, um einen zweiten Hohlraum (51) zu bilden.

6. Verfahren zur Herstellung einer Halbleitervorrichtung, die einen Resonator enthält, nach Anspruch 5, das ferner, nach dem Schritt des Erhitzens der Vorrichtung zum Zersetzen des thermisch zersetzbaren Polymers, das Abscheiden eines Prämetall-Dielektrikums (52) über der permeablen dielektrischen Schicht (50) und das Einebnen des Prämetall-Dielektrikums (52) durch chemisch-mechanisches Polieren umfasst.

7. Verfahren zur Herstellung einer Halbleitervorrichtung, die einen Resonator nach Anspruch 6 enthält, ferner das Bilden einer Multischicht-Metallisierung (54) über dem Prämetall-Dielektrikum (52) umfassend.

8. Verfahren nach irgendeinem der Ansprüche 5 bis 7, das ferner das Ätzen einer Öffnung (56) von der oberen Oberfläche der Halbleitervorrichtung durch die permeable dielektrische Schicht (50) zu dem zweiten Hohlraum (51) umfasst, um den Hohlraum freizulegen.

## Revendications

1. Procédé de fabrication d'un résonateur (40), comprenant :
la formation d'une structure FINFET avec un substrat (2), une couche d'oxyde enterrée (4) sur le substrat (2), une couche de semi-conducteur (6) sur la couche d'oxyde enterrée, la couche de semi-conducteur étant façonnée de manière à définir quatre régions de semi-conducteur se réunissant dans une région centrale (8), les quatre régions comprenant une première et une deuxième région opposées (10, 12) reliées par une barre centrale (14), et une troisième et une quatrième région opposées (16, 18) de chaque côté de la barre centrale (14), avec un isolant d'oxyde (20) entre chacune des troisième et quatrième régions (16, 18) et la barre centrale (14) ; et
la gravure sélective de la couche d'oxyde enterrée (4) et de l'isolant d'oxyde (20) dans la région centrale (8) pour former une cavité (22) sous la barre centrale (14) et pour dégager par gravure l'isolant d'oxyde (20) entre le troisième et la quatrième région (16, 18) et la barre centrale, de sorte que la barre centrale (14) forme un élément de résonateur (30), que les première et deuxième régions forment les points d'ancrage du résonateur (32, 34), et que les troisième et quatrième régions forment les électrodes de commande et de détection (36, 38).

2. Procédé selon la revendication 1 dans lequel l'étape de formation d'une structure FINFET comporte :
la formation d'une première couche de semi-conducteur (5) sur la couche d'oxyde enterrée ;
le façonnage de la première couche de semi-conducteur (5) pour former la première et la deuxième régions (10, 12) et la barre centrale (14) ;
le dépôt d'isolant d'oxyde (20) sur la barre centrale (14) ;
le dépôt d'une deuxième couche de semi-conducteur (7) ; et
le façonnage de la deuxième couche de semi-conducteur (7) pour former la troisième et la quatrième région (16, 18) de chacun des côtés de la région centrale, séparées de la barre centrale (14) par l'isolant d'oxyde.

3. Procédé selon la revendication 2, dans lequel l'étape de façonnage de la deuxième couche de semi-conducteur comporte la réalisation d'une étape de polissage chimico-mécanique destinée à éliminer la deuxième couche de semi-conducteur (7) au-dessus d'un niveau prédéterminé afin d'éliminer la deuxième couche de semi-conducteur au-dessus de la barre centrale (14).

4. Procédé selon les revendications 2 ou 3 dans lequel les étapes de façonnage d'au moins une couche parmi la première couche de semi-conducteur et la deuxième couche de semi-conducteur impliquent la formation d'un masque dur, le façonnage du masque dur, puis l'utilisation du masque dur pour graver la couche de semi-conducteur correspondante.

5. Procédé de fabrication d'un dispositif à semi-conducteurs contenant un résonateur, le procédé comprenant :
la disposition d'un substrat (2) ;
la formation d'une couche d'oxyde enterrée (4) sur le substrat (2) ;
la formation d'un résonateur (40) sur le substrat dans une région de résonateur (42) du substrat en utilisant un procédé selon l'une quelconque des revendications 1 à 4 et la formation d'au moins un dispositif actif (44) sur au moins une région de dispositif actif (46) du substrat ;
le dépôt et le façonnage d'un polymère pouvant se décomposer thermiquement (48) sur la région du résonateur (42) ;
le dépôt d'une couche diélectrique perméable (50) sur la région du dispositif actif (46) et sur le polymère pouvant se décomposer thermiquement (48) au-dessus de la région du résonateur (42) ;
le chauffage du dispositif pour décomposer le polymère pouvant se décomposer thermiquement afin de former une deuxième cavité (51).

6. Procédé de fabrication d'un dispositif à semi-conducteurs contenant un résonateur selon la revendication 5 comprenant en outre, après l'étape de chauffage du dispositif pour décomposer le polymère pouvant être décomposé thermiquement, le dépôt d'un diélectrique de pré-métallisation (52) sur la couche de diélectrique perméable (50), et l'aplanissement du diélectrique de pré-métallisation (52) par polissage chimico-mécanique.

7. Procédé de fabrication d'un dispositif à semi-conducteurs contenant un résonateur selon la revendication 6 comprenant en outre la formation d'une métallisation multicouches (54) sur le diélectrique de pré-métallisation (52).

8. Procédé selon l'une quelconque des revendications 5 à 7 comprenant en outre la gravure d'une ouverture (56) à partir de la surface supérieure du dispositif à semi-conducteurs à travers la couche de diélectrique perméable (50) vers la deuxième cavité (51) pour exposer la cavité.
